# EUROPEAN PATENT APPLICATION

(11) **EP 1 542 264 A1**
(43) Date of publication of application: **15.06.2005**
(21) Application number: 03712689.3
(22) Date of filing: 13.03.2003
(51) Int. Cl.: H01L 21/205

(54) **CVD APPARATUS HAVING MEANS FOR CLEANING WITH FLUORINE GAS AND METHOD OF CLEANING CVD APPARATUS WITH FLUORINE GAS**

(30) Priority: 01.07.2002 JP 2002192311
(71) Applicant: Research Institute of Innovative Technology for the Earth, Soraku-gun, Kyoto 619-0292 (JP); National Institute of Advanced Industrial Science and Technology, Tokyo 100-8921 (JP)
(72) Inventor: BEPPU, T., Minato-ku, Tokyo 105-0003 (JP); SAKAI, Katsuo, Minato-ku, Tokyo 105-0003 (JP); OKURA, Seiji, Minato-ku, Tokyo 105-0003 (JP); SAKAMURA, Masaji, Minato-ku, Tokyo 105-0003 (JP); ABE, Kaoru, Minato-ku, Tokyo 105-0003 (JP); MURATA, Hitoshi, Minato-ku, Tokyo 105-0003 (JP); WANI, Etsuo, Minato-ku, Tokyo 105-0003 (JP); KAMEDA, Kenji, Minato-ku, Tokyo 105-0003 (JP); MITSUI, Yuki, Minato-ku, Tokyo 105-0003 (JP); OHIRA, Yutaka, Minato-ku, Tokyo 105-0003 (JP); YONEMURA, Taisuke, Minato-ku, Tokyo 105-0003 (JP); SEKIYA, Akira, Minato-ku, Tokyo 105-0003 (JP)
(74) Representative: Jackson, Robert Patrick
(86) International application number: PCT/JP2003/003021
(87) International publication number: WO 2004/003983

(57) **Abstract**

It is an object to provide a cleaning method in a CVD apparatus capable of efficiently removing a by-product such as SiO₂ or Si₃N₄ which is adhered to and deposited on the surfaces of an inner wall, an electrode and the like in a reaction chamber at a film forming step. Furthermore, it is an object to provide a cleaning method in which the amount of a cleaning gas to be discharged is very small, an influence on an environment such as global warming is also lessened and a cost can also be reduced.

An energy is applied to a fluorine compound to react the fluorine compound, thereby generating a fluorine gas component and a component other than the fluorine gas component. Furthermore, the fluorine gas component and the component other than the fluorine gas component which are generated are separated from each other so that the fluorine gas component is separated and refined. After a film forming process for a base material is carried out by a CVD apparatus, a separated and refined fluorine gas is then converted to a plasma to remove a by-product adhered into the reaction chamber.

## Description

### TECHNICAL FIELD

The present invention relates to a chemical vapor deposition (CVD) apparatus for forming a uniform thin film of high quality, for example, silicon oxide (SiO₂) or silicon nitride (Si₃N₄ or the like) on a surface of a base material for a semiconductor such as a silicon wafer.

In more detail, the present invention relates to a CVD apparatus capable of executing cleaning for removing a by-product adhered to an inner wall of a reaction chamber or the like after a thin film forming process, and a method of cleaning the CVD apparatus using the same.

### BACKGROUND ART

Conventionally, a thin film such as silicon oxide (SiO₂) or silicon nitride (Si₃N₄ or the like) is widely used in a semiconductor element such as a thin film transistor, a photoelectric converting element or the like. The following three kinds of techniques for forming a thin film such as silicon oxide, silicon nitride or the like are mainly used.
(1) Physical vapor-phase film forming technique such as sputtering or vacuum deposition
   more specifically, a technique for converting a solid thin film material to an atom or an atomic group to be physical means and depositing the same on a surface of a formed film, thereby forming a thin film;
(2) Thermal CVD technique
   more specifically, a technique for heating a gaseous thin film material to a high temperature so as to induce chemical reaction, thereby forming a thin film; and
(3) Plasma CVD technique
   more specifically, a technique for converting a gaseous thin film material to a plasma so as to induce chemical reaction, thereby forming a thin film.

In particular, the plasma CVD technique (plasma enhanced chemical vapor deposition) in (3) is widely used because a minute and uniform thin film can efficiently be formed.

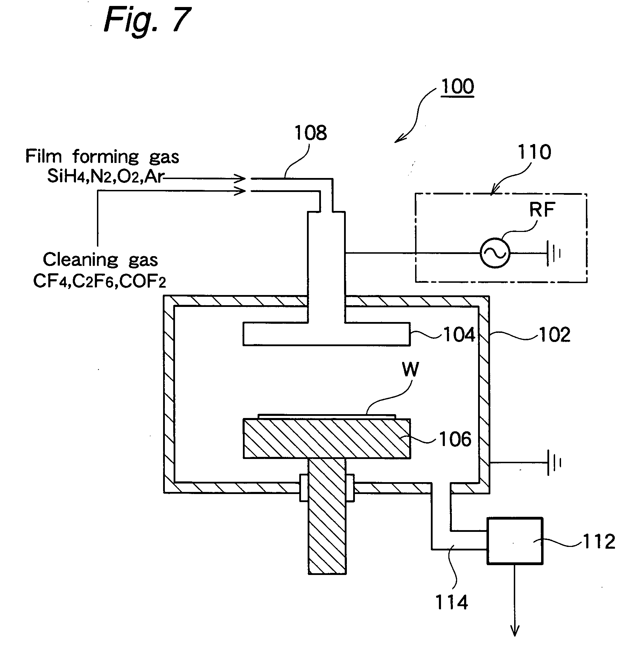

A plasma CVD apparatus 100 to be used in the plasma CVD technique is generally constituted as shown in Fig. 7.

More specifically, the plasma CVD apparatus 100 comprises a reaction chamber 102 maintained in a decompression state, and an upper electrode 104 and a lower electrode 106 are provided to be opposed apart from each other at a constant interval in the reaction chamber 102. A film forming gas supply path 108 connected to a film forming gas source (not shown) is connected to the upper electrode 104, and a film forming gas is supplied into the reaction chamber 102 through the upper electrode 104.

Moreover, a high frequency applicator 110 for applying a high frequency is connected to the reaction chamber 102 in the vicinity of the upper electrode 104. Furthermore, an exhaust path 114 for exhausting a gas through a pump 112 is connected to the reaction chamber 102.

In the plasma CVD apparatus 100 thus constituted, for example, monosilane (SiH₄), N₂O, N₂, O₂, Ar or the like in the formation of the film of silicon oxide (SiO₂) and the monosilane (SiH₄), NH₃, N₂, O₂, Ar or the like in the formation of the film of silicon nitride (Si₃N₄ or the like) are introduced through the film forming gas supply path 108 and the upper electrode 104 into the reaction chamber 102 which is maintained in a decompression state of 130 Pa, for example. In this case, a high frequency power of 13.56 MHz is applied between the electrodes 104 and 106, which are provided opposite to each other in the reaction chamber 102, through the high frequency applicator 110, for example. As a result, a high frequency electric field is generated, electrons are impacted with neutral molecules of a film forming gas in the electric field, and a high frequency plasma is formed so that the film forming gas is dissociated into ions and radicals. By the actions of the ions and radicals, a silicon thin film is formed on a surface of a semiconductor product W such as a silicon wafer which is provided on one of the electrodes (the lower electrode 106).

In such a plasma CVD apparatus 100, at a film forming step, a thin film material such as SiO₂ or Si₃N₄ is also adhered to and deposited on the surfaces of an inner wall, an electrode and the like in the reaction chamber 102 other than the semiconductor product W to be formed by a discharge in the reaction chamber 102 so that a by-product is obtained. When this by-product grows to have a constant thickness, it is peeled by a dead weight, a stress or the like. At the film forming step, consequently, fine particles to be foreign matters are mixed into the semiconductor product so that contamination is caused. For this reason, a thin film of high quality cannot be manufactured so that the disconnection or short-circuit of a semiconductor circuit is caused. In addition, there is a possibility that a yield or the like might be deteriorated.

For this reason, conventionally, a by-product is removed by using, for example, a cleaning gas obtained by adding a fluorocompound such as CF₄, C₂F₆ or COF₂, and O₂ or the like if necessary in order to remove such a by-product at any time after the film forming step is ended in the plasma CVD apparatus 100.

More specifically, in a method of cleaning the conventional plasma CVD apparatus 100 using such a cleaning gas, after the film forming step is ended as shown in Fig. 7, a cleaning gas containing a fluorocompound such as the CF₄, the C₂F₆ or the COF₂ is accompanied by a gas such as O₂ and/or Ar in place of a film forming gas in the film formation. Thereafter, the cleaning gas is introduced into the reaction chamber 102, which is maintained in a decompression state, through the film forming gas supply path 108 and the upper electrode 104. In the same manner as the film formation, a high frequency power is applied between the electrodes 104 and 106, which are provided opposite to each other in the reaction chamber 102, through the high frequency applicator 110. As a result, a high frequency electric field is generated, electrons are impacted with the neutral molecules of the cleaning gas in the electric field, and a high frequency plasma is formed so that the cleaning gas is dissociated into ions and radicals. The ions and the radicals react to a by-product such as SiO₂ or Si₃N₄ which is adhered to and deposited on the surfaces of an inner wall, an electrode and the like in the reaction chamber 102. As a result, the by-product is gasified as SiF₄ and is discharged from the pump 112 to the outside of the reaction chamber 102 through the exhaust path 114 together with an exhaust gas.

The fluorocompound such as CF₄ or C₂F₆ to be used as the cleaning gas is a stable compound having a long life in the atmospheric air. Furthermore, there is a problem in that a gas discharging process is hard to perform after the cleaning and a disposal cost is increased. Moreover, global warming factors (values for a cumulative period of 100 years) of CF₄, C₂F₆ and SF₆ are 6500, 9200 and 23900 respectively, and they are extremely large. Therefore, an adverse influence thereof on an environment is apprehended.

Moreover, the ratio of a gas discharged to the outside of the reaction chamber 102 through the exhaust path 114 is high, that is, approximately 60% in case of C₂F₆, for example. Therefore, it has an adverse influence on global warming, and a dissociation efficiency is low and a cleaning capability is also low.

Furthermore, in plasma cleaning, an added gas such as oxygen or argon is usually mixed in a proper amount and is thus used together with a cleaning gas.

In a mixed gas type of the cleaning gas and the added gas, when the content concentration of the cleaning gas is increased under the condition that a total gas flow is constant, an etching speed tends to be increased. If the concentration of the cleaning gas is more than a certain concentration, however, there is a problem in that the generation of a plasma becomes unstable, the etching speed is decreased or a cleaning uniformity is deteriorated. If the cleaning gas is used in a concentration of 100%, particularly, there is a problem in that the instability of the generation of the plasma, the decrease in the etching speed and the deterioration in the cleaning uniformity tend to be more remarkable so that a utility cannot be obtained.

For this reason, the cleaning gas is to be diluted for use in such a manner that a concentration thereof is reduced to be equal to or lower than the peak concentration of an etching speed and cleaning gas concentration curve. In order to suppress a decrease in the etching speed with the dilution, cleaning conditions are optimized by raising a chamber pressure or increasing a gas flow in the cleaning. If the chamber pressure is raised or the gas flow is increased in the cleaning, however, the generation of a plasma becomes unstable and the cleaning uniformity is deteriorated so that the cleaning cannot be efficiently carried out.

Therefore, the inventors vigorously made a study. As a result, it was found that a fluorine gas rarely influences the environment and a plasma can be stably generated under the condition that a total gas flow is approximately 1000 sccm and a chamber pressure is approximately 400 Pa by using the fluorine gas as a cleaning gas. In addition, a plasma processing can be carried out, a very excellent etching speed can be obtained, and furthermore, an excellent cleaning uniformity can be maintained.

Moreover, it was known that an F atom generated by the plasma has a stability and a gas discharged by using the fluorine gas as a cleaning gas is the fluorine gas, and the cleaning process can be efficiently carried out by using the fluorine gas in a necessary amount as the cleaning gas.

However, the conventional fluorine gas generating device for generating a fluorine gas has such a structure that KF is dissolved as an electrolyte in an HF anhydride solution and an electrolyte is electrolyzed by a carbon electrode to obtain the fluorine gas.

Such a conventional fluorine gas generating device is large-sized and cannot be used safely. Therefore, it is necessary for a special safety administrator to carry out maintenance. If the fluorine gas generating device is used in a CVD apparatus, the size of the CVD apparatus is increased, and furthermore, a complicated work is required for maintenance and control.

In the case in which such a fluorine gas is used as the cleaning gas of the CVD apparatus, the cleaning gas is required in an amount of 750 sccm per wafer for one minute. In order to process 3000 wafers, the fluorine gas is required in an amount of 100 moles, that is, 3.8 kg. If this amount is converted into a 29 atm filled 47L cylinder, two cylinders are required for one reaction chamber. Also when a fluorine gas cylinder is provided in the CVD apparatus in place of the conventional fluorine gas generating device, accordingly, the size of the apparatus is increased, and furthermore, the exchange of the cylinder is complicated, which is inconvenient.

In consideration of such actual circumstances, it is an object of the present invention to provide a CVD apparatus capable of executing cleaning in which a by-product such as SiO₂ or Si₃N₄, which is adhered to and deposited on the surfaces of an inner wall, an electrode and the like in a reaction chamber, can efficiently be removed at a film forming step. Furthermore, the present invention is to provide a CVD apparatus in which the amount of a cleaning gas to be discharged is very small, the influence on an environment such as global warming is also lessened, a gas utilization efficiency is also high and a cost can also be reduced and of manufacturing a thin film of high quality, and having a small-sized cleaning mechanism. In addition, the present invention is to provide a method of cleaning the CVD apparatus using the CVD apparatus.

### DISCLOSURE OF THE INVENTION

The present invention has been made in order to solve the problems and to attain the object in the prior art described above, and the present invention provides a CVD apparatus having a cleaning mechanism for supplying a reactive gas into a reaction chamber and forming a deposited film on a surface of a base material provided in the reaction chamber, comprising a fluorine gas generating device including:
an energy applying device configured to apply an energy to a fluorine compound to react the fluorine compound, thereby generating a fluorine gas component and a component other than the fluorine gas component; and
a fluorine gas concentration/separation refining device configured to separate the fluorine gas component and the component other than the fluorine gas component which are generated by the energy applying device, thereby separating and refining the fluorine gas component,
wherein after a film forming process for the base material is carried out by the CVD apparatus, a fluorine gas, which is separated and refined by the fluorine gas generating device, is then converted to a plasma to remove a by-product adhered into the reaction chamber.

Moreover, the present invention provides a method of cleaning a CVD apparatus for supplying a reactive gas into a reaction chamber and forming a deposited film on a surface of a base material provided in the reaction chamber, comprising:
applying an energy to a fluorine compound to react the fluorine compound, thereby generating a fluorine gas component and a component other than the fluorine gas component; and
separating the fluorine gas component and the component other than the fluorine gas component which are generated, thereby separating and refining the fluorine gas component,
wherein after a film forming process for the base material is carried out by the CVD apparatus, a separated and refined fluorine gas is then converted to a plasma to remove a by-product adhered into the reaction chamber.

Thus, the energy is simply applied to react the fluorine compound so that the fluorine gas component and the component other than the fluorine gas component are generated and separated. Consequently, the fluorine gas component is separated and refined so that the fluorine gas can easily be obtained.

Accordingly, after the film forming process for the base material is carried out by the CVD apparatus, the fluorine gas thus obtained is then converted to a plasma. By using the plasma to remove a by-product adhered into the reaction chamber, it is possible to obtain a very excellent etching speed. Thus, an excellent cleaning uniformity can be maintained.

In addition, such a fluorine gas generating device has a smaller size as compared with a conventional fluorine gas generating device using electrolysis, and furthermore, the fluorine gas can be obtained efficiently. The CVD apparatus itself is also small-sized and maintenance can easily be carried out.

Moreover, the present invention provides the CVD apparatus having a cleaning mechanism, wherein the energy applying device is constituted to heat the fluorine compound, thereby reacting the fluorine compound to generate the fluorine gas component and the component other than the fluorine gas component.

Furthermore, the present invention provides the method of cleaning a CVD apparatus, wherein the fluorine compound is heated and is thus reacted, thereby generating the fluorine gas component and the component other than the fluorine gas component.

By simply heating the fluorine compound, thus, the fluorine compound is reacted to generate the fluorine gas component and the component other than the fluorine gas component. Consequently, the fluorine gas component can be obtained. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

In addition, the present invention provides the CVD apparatus having a cleaning mechanism, wherein the energy applying device is constituted to apply a plasma to the fluorine compound, thereby reacting the fluorine compound to generate the fluorine gas component and the component other than the fluorine gas component.

Moreover, the present invention provides the method of cleaning a CVD apparatus, wherein a plasma is applied to the fluorine compound, thereby reacting the fluorine compound to generate the fluorine gas component and the component other than the fluorine gas component.

By simply applying a plasma to the fluorine compound, thus, the fluorine compound is reacted to generate the fluorine gas component and the component other than the fluorine gas component. Consequently, the fluorine gas component can be obtained. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

Furthermore, the present invention provides the CVD apparatus having a cleaning mechanism, wherein the energy applying device is constituted to react the fluorine compound by a catalyst, thereby generating the fluorine gas component and the component other than the fluorine gas component.

Moreover, the present invention provides the method of cleaning a CVD apparatus, wherein the fluorine compound is reacted by a catalyst, thereby generating the fluorine gas component and the component other than the fluorine gas component.

By simply reacting the fluorine compound through the catalyst, thus, the fluorine gas component and the component other than the fluorine gas component are generated so that the fluorine gas component can be obtained. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

Moreover, the present invention provides the CVD apparatus having a cleaning mechanism, wherein the fluorine gas concentration/separation refining device is constituted to separate the fluorine gas component from the component other than the fluorine gas component by utilizing a difference in a boiling point which is made by cooling.

Furthermore, the present invention provides the method of cleaning a CVD apparatus, wherein the fluorine gas component is separated from the component other than the fluorine gas component by utilizing a difference in a boiling point which is made by cooling.

Thus, the fluorine gas component is separated from the component other than the fluorine gas component by utilizing the difference in the boiling point through cooling, trapping using liquid nitrogen, electron cooling or the like, for example. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

In addition, the present invention is characterized in that the fluorine compound contains nitrogen.

If the fluorine compound contains the nitrogen, thus, examples of the fluorine compound containing the nitrogen include FNO and F₃NO. The FNO is a stable substance. By using the FNO as a fluorine gas source, it is possible to utilize the fluorine gas as a cleaning gas more stably.

Moreover, the present invention is characterized in that the fluorine compound contains chlorine.

Thus, if the fluorine compound contains the chlorine, for example, such fluorine compound is ClF₃. In this case, the ClF₃ is decomposed into ClF and F₂. Referring to the ClF and the F₂, the boiling point of the ClF is -101°C and that of the F₂ is -188.1°C, which are different from each other. By carrying out trapping or the like using liquid nitrogen, dry ice or the like, for example, it is possible to easily separate the fluorine gas.

Furthermore, the present invention is characterized in that the fluorine compound contains iodine.

Thus, if the fluorine compound contains the iodine, for example, such fluorine compound is IF₅ or IF₇. In this case, a product such as IF₃ has a different boiling point from that of F₂. Therefore, it is possible to easily separate the fluorine gas by using a refrigerant such as liquid nitrogen, dry ice or the like, for example.

In addition, the present invention is characterized in that the fluorine compound contains sulfur.

Thus, if the fluorine compound contains the sulfur, for example, such fluorine compound is SF₆. In this case, the boiling point of SO₂F₂ is -83.1°C,that of SO₂ is -10°C and that of F₂ is -188.1°C, which are different from each other. By carrying out trapping or the like using liquid nitrogen, dry ice or the like, for example, it is possible to easily separate the fluorine gas.

Moreover, the present invention is characterized in that the fluorine compound contains carbon.

Thus, if the fluorine compound contains the carbon, for example, such fluorine compound is CF₄, COF₂ or C₂F₆. In this case, products such as CO₂ (a boiling point of -78.5°C), the COF₂ (a boiling point of -83.1°C), the C₂F₆ (a boiling point of -78.2°C) and the CF₄ have different boiling points from the boiling point of F₂ (a boiling point of -188.1°C). Therefore, it is possible to easily separate the fluorine gas by carrying out trapping or the like using liquid nitrogen, dry ice or the like, for example.

### BRIEF DESCRIPTION OF THE DRAWINGS

Fig. 1 is a schematic view showing a first example of a CVD apparatus having a cleaning mechanism according to the present invention.

Fig. 2 is a schematic view showing a cleaning gas generating device 40 in Fig. 1,

Fig. 3 is a schematic view showing a second example of the CVD apparatus having the cleaning mechanism according to the present invention.

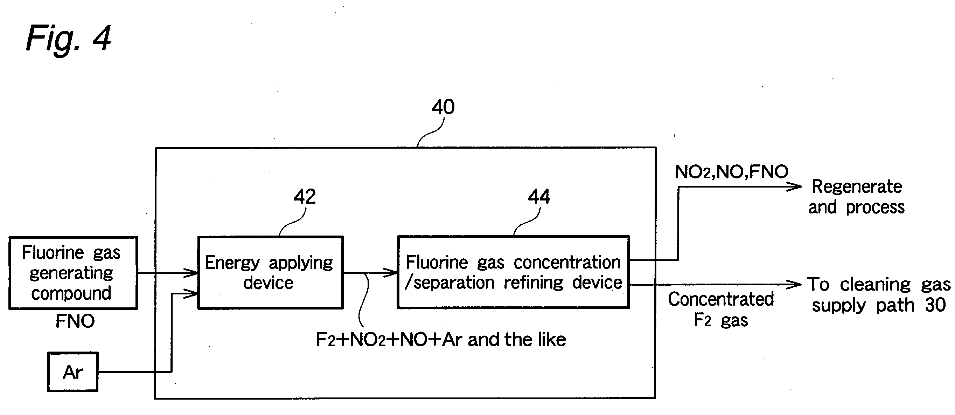

Fig. 4 is the same schematic view as Fig. 2 showing the first example of the CVD apparatus having the cleaning mechanism according to the present invention.

Fig. 5 is the same schematic view as Fig. 2 showing the second example of the CVD apparatus having the cleaning mechanism according to the present invention.

Fig. 6 is the same schematic view as Fig. 2 showing a third example of the CVD apparatus having the cleaning mechanism according to the present invention.

Fig. 7 is a schematic view showing a plasma CVD apparatus to be used for a conventional plasma CVD method.

### BEST MODE FOR CARRYING OUT THE INVENTION

Embodiments (examples) of the present invention will be described below in more detail with reference to the drawings.

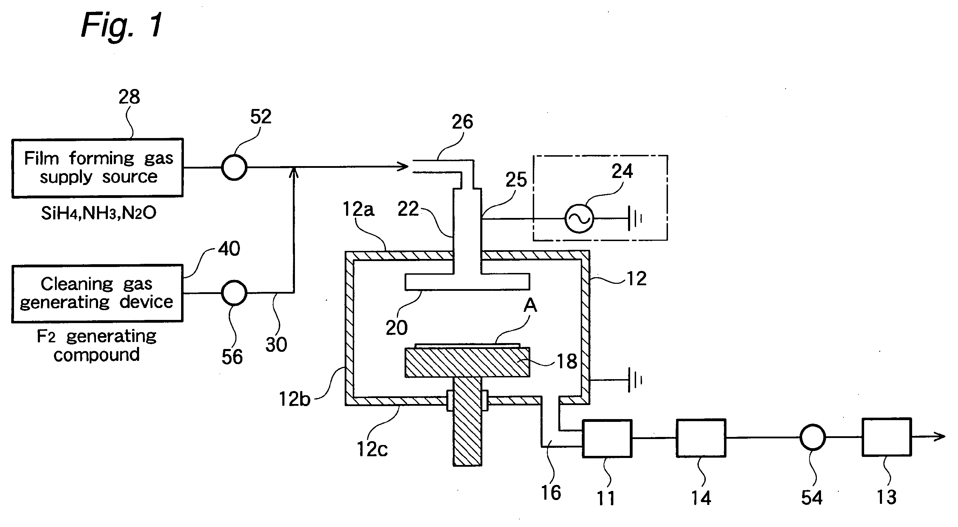

Fig. 1 is a schematic view showing a first example of a CVD apparatus having a cleaning mechanism according to the present invention.

Description will be given to a plasma CVD apparatus having a cleaning mechanism to be used in a plasma CVD method as shown in Fig. 1. A CVD apparatus 10 comprises a reaction chamber 12 maintained in a decompression state (a vacuum state). In addition, the reaction chamber 12 is maintained in a constant vacuum state (a decompression state) by discharging an internal gas to the outside through an exhaust path 16 formed on a bottom wall 12c of the reaction chamber 12, by means of a mechanical booster pump 11, a dry pump 14 and a toxicity removing device 13 for causing an exhaust gas to be nontoxic.

Moreover, a lower electrode 18 constituting a stage for mounting a base material A to deposit (vapor deposit or the like) a silicon thin film on a surface of a silicon wafer or the like, for example, is provided in the reaction chamber 12. The lower electrode 18 penetrates through the bottom wall 12c of the reaction chamber 12 and is constituted vertically slidably by a driving mechanism which is not shown, and a position can be adjusted. A sliding portion between the lower electrode 18 and the bottom wall 12c is provided with a seal member such as a seal ring in order to maintain a degree of vacuum in the reaction chamber 12, which is not shown.

On the other hand, an upper electrode 20 is provided in the upper part of the reaction chamber 12. Furthermore, the upper electrode 20 has a base end portion 22 thereof which penetrates through a top wall 12a of the reaction chamber 12 and is connected to a high frequency power source 24 provided on the outside of the reaction chamber 12. The upper electrode 20 is provided with a high frequency applicator 25 such as a high frequency application coil which is not shown. Moreover, a matching circuit (not shown) is provided between the high frequency applicator 25 and the high frequency power source 24. Consequently, it is possible to propagate a high frequency generated by the high frequency power source 24 to the high frequency applicator 25 such as the high frequency application coil without a loss.

Moreover, a reactive gas supply path 26 is formed on the upper electrode 20. In addition, a film forming gas is introduced from a film forming gas supply source 28 into the reaction chamber 12, which is maintained in a decompression state, through the reactive gas supply path 26 and the upper electrode 20.

On the other hand, a cleaning gas supply path 30 is branched and connected to the reactive gas supply path 26. In addition, a cleaning gas can be introduced from a cleaning gas generating device 40 into the reaction chamber 12 through the cleaning gas supply path 30.

The CVD apparatus 10 according to the present invention having such a structure is operated in the following manner.

First of all, the base material A for depositing a silicon thin film on a surface of a silicon wafer or the like, for example, is mounted over the stage of the lower electrode 18 in the reaction chamber 12. Thereafter, a distance from the upper electrode 20 is regulated to be a predetermined distance by a driving mechanism which is not shown.

An internal gas is discharged to the outside through the dry pump 14 via the exhaust path 16 formed on the bottom wall 12c in the reaction chamber 12. Consequently, a constant vacuum state (a decompression state), for example, a decompression state of 10 to 2000 Pa is maintained.

A switching valve 52 provided on the reactive gas supply path 26 is opened and a film forming gas is introduced from the film forming gas supply source 28 into the reaction chamber 12, which is maintained in the decompression state, through the reactive gas supply path 26 and the upper electrode 20.

At this time, the switching valve 52 provided on the reactive gas supply path 26 and a switching valve 54 provided on the exhaust path 16 are opened. On the other hand, a switching valve 56 provided on the cleaning gas supply path 30 is closed.

In this case, it is preferable that monosilane (SiH₄), N₂O, N₂, O₂, Ar and the like in the formation of the film of silicon oxide (SiO₂) and the monosilane (SiH₄), NH₃, N₂, O₂ and Ar in the formation of the film of silicon nitride (Si₃N₄ or the like) should be supplied as the film forming gas which is to be supplied from the film forming gas supply source 28, for example. However, the film forming gas is not restricted to them but they can properly be changed, for example, disilane (Si₂H₆), TEOS (tetraethoxysilane ; Si(OC₂H₅)₄) or the like is used as the film forming gas and O₂, O₃ or the like is used as a carrier gas depending on the type of a thin film to be formed, for example.

A high frequency electric field is generated from the high frequency applicator 25 such as a high frequency application coil to the upper electrode 20 by a high frequency generated from the high frequency power source 24. Then, electrons are impacted with neutral molecules of the film forming gas in the electric field. As a result, a high frequency plasma is formed and the film forming gas is dissociated into ions and radicals. By the actions of the ions and radicals, a silicon thin film is formed on the surface of the base material A such as a silicon wafer which is provided on the lower electrode 18.

In such a CVD apparatus 10, at a film forming step, a thin film material such as SiO₂ or Si₃N₄ is also adhered to and deposited on the surfaces of an inner wall, an electrode and the like in the reaction chamber 12 other than a semiconductor product A to be formed. As a result, a by-product is obtained by a discharge in the reaction chamber 12. When this by-product grows to have a constant thickness, it is peeled and scattered by a dead weight, a stress or the like. At the film forming step, consequently, fine particles to be foreign matters are mixed into the semiconductor product so that contamination is caused. For this reason, a thin film of high quality cannot be manufactured so that the disconnection or short-circuit of a semiconductor circuit is caused. In addition, there is a possibility that a yield or the like might also be deteriorated.

In the CVD apparatus 10 according to the present invention, therefore, a cleaning gas supplied from the cleaning gas generating device 40 is introduced into the reaction chamber 12 through the cleaning gas supply path 30.

More specifically, after the thin film processing is ended as described above, the switching valve 52 provided on the reactive gas supply path 26 is closed so that the supply of the film forming gas from the film forming gas supply source 28 into the reaction chamber 12 is stopped.

Then, the switching valve 56 provided on the cleaning gas supply path 30 is opened so that the cleaning gas is introduced from the cleaning gas generating device 40 into the reaction chamber 12 through the cleaning gas supply path 30.

Thereafter, a high frequency electric field is generated from the high frequency applicator 25 such as a high frequency application coil to the upper electrode 20, by the high frequency generated from the high frequency power source 24. As a result, a high frequency plasma is formed. Consequently, the cleaning gas is dissociated into ions and radicals, and the ions and the radicals react to a by-product such as SiO₂ or Si₃N₄ which is adhered to and deposited on the surfaces of the inner wall, the electrode and the like in the reaction chamber 12. As a result, the by-product is changed into a gas as SiF₄.

Subsequently, the by-product thus changed into the gas is discharged through the exhaust path 16.

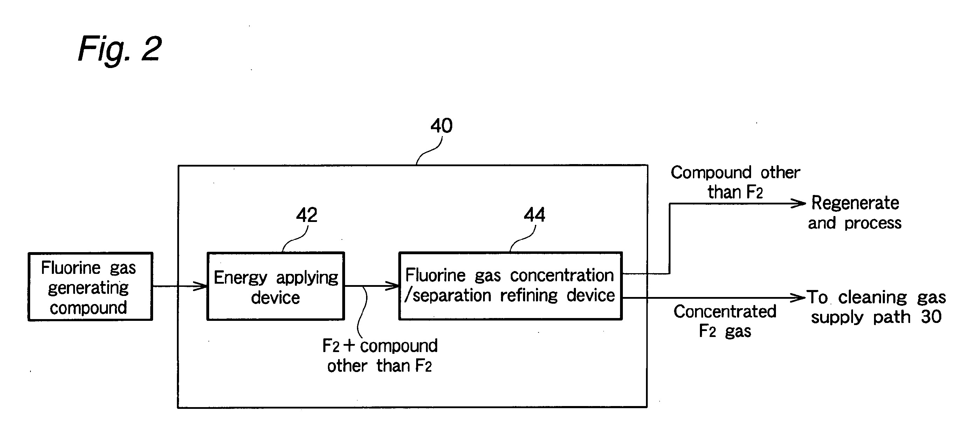

As shown in Fig. 2, the cleaning gas generating device 40 includes an energy applying device 42. The energy applying device 42 is constituted to apply an energy to a cleaning gas material comprising a fluorine compound thereby reacting the fluorine compound, so that a fluorine gas component and a component other than the fluorine gas component are generated.

The fluorine gas component is separated and refined from the fluorine gas component and the component other than the fluorine gas component, which are generated in the energy applying device 42, by means of a fluorine gas concentration/separation refining device 44. The fluorine gas separated and refined by the fluorine gas concentration/separation refining device 44 is introduced as a cleaning gas into the reaction chamber 12 through the cleaning gas supply path 30.

On the other hand, if the components other than the fluorine gas component, from which the fluorine gas is separated by the fluorine gas concentration/separation refining device 44, can be regenerated (not shown), they are separately regenerated by a regenerating device (not shown) depending on the components. On the other hand, if the components other than the fluorine gas component do not need to be regenerated, they are separately processed by a processing device (not shown) and are discharged or used for another processing.

For the cleaning gas material comprising the fluorine compound, a fluorine compound containing nitrogen can be used. For such a fluorine compound containing the nitrogen, for example, NF₃, FNO and F₃NO can be used. In this case, for example, if the fluorine compound containing the nitrogen is FNO, the FNO is a stable substance. By using the FNO as a fluorine gas source, it is possible to utilize the fluorine gas as the cleaning gas more stably.

For the cleaning gas material comprising the fluorine compound, moreover, it is possible to use a fluorine compound containing chlorine. For such a fluorine compound containing the chlorine, it is possible to use ClF₃, for example. In this case, for example, if the fluorine compound containing the chlorine is ClF₃, the ClF₃ is decomposed into ClF and F₂. The ClF and the F₂ have different boiling points from each other, that is, the ClF has a boiling point of -101°C and the F₂ has a boiling point of -188.1°C. By carrying out trapping using liquid nitrogen, dry ice or the like, for example, it is possible to easily separate the fluorine gas.

For the cleaning gas material comprising the fluorine compound, moreover, it is possible to use a fluorine compound containing iodine. For such a fluorine compound containing the iodine, for example, it is possible to use IF₅ and IF₇. In this case, if the fluorine compound containing the iodine is the IF₅ or the IF₇, a product such as IF₃ has a different boiling point from that of F₂. By using a refrigerant such as liquid nitrogen or dry ice, for example, it is possible to easily separate the fluorine gas.

For the cleaning gas material comprising the fluorine compound, moreover, it is possible to use a fluorine compound containing sulfur. For such a fluorine compound containing the sulfur, SF₆ can be used, for example. In this case, if the fluorine compound containing the sulfur is the SF₆, products such as SO₂F₂ and SO₂ have different boiling points, that is, the SO₂F₂ has a boiling point of -83.1°C, the SO₂ has a boiling point of -10°C and the F₂ has a boiling point of -188.1°C. By carrying out the trapping using the liquid nitrogen, the dry ice or the like, for example, it is possible to easily separate the fluorine gas.

For the cleaning gas material comprising the fluorine compound, furthermore, it is possible to use a fluorine compound containing carbon. For such a fluorine compound containing the carbon, for example, it is possible to use CF₄, COF₂ and C₂F₆. In this case, if the fluorine compound containing the carbon is the CF₄, the COF₂ or the C₂F₆, products such as CO₂ (a boiling point of -78.5°C), the COF₂ (a boiling point of -83.1°C), the C₂F₆ (a boiling point of -78.2°C) and the CF₄ have different boiling points from the boiling point of the F₂ (a boiling point of -188.1°C). By carrying out the trapping using the liquid nitrogen, the dry ice or the like, for example, it is possible to easily separate the fluorine gas.

Moreover, the energy applying device 42 serves to only apply an energy to a fluorine compound, thereby carrying out reaction to generate a fluorine gas component and a component other than the fluorine gas component. For example, therefore, it is possible to use a heating device for heating the fluorine compound, a plasma applying device for applying a plasma to the fluorine compound, a catalyst decomposing device, a light exciting device using an ultraviolet xenon lamp or an excimer laser or the like.

In this case, only by heating the fluorine compound or applying a plasma to the fluorine compound using the heating device, the plasma applying device or the like, it is possible to react a fluorine compound and to generate a fluorine gas component and a component other than the fluorine gas component. As a result, the fluorine gas component can be obtained. As compared with a conventional fluorine gas generating device using electrolysis, therefore, a size can be more reduced, and furthermore, the fluorine gas can be obtained more efficiently. In addition, a CVD apparatus itself is also small-sized and maintenance can easily be carried out.

In this case, the heating device is not particularly restricted but heating using an electric furnace or the like can be used. A heating temperature and a heating time may be properly selected depending on the type of the fluorine compound to be used.

More specifically, if the fluorine compound contains nitrogen, for example, is FNO, it is desirable that decomposition should be carried out at an atmospheric pressure or a reduced pressure by using the plasma device.

In this case, the plasma applying device may be a well-known plasma generating device to be used at a reduced pressure or an atmospheric pressure and is not particularly restricted. By way of example, "ASTRON" (manufactured by ASTEX Co., Ltd.) can be used.

If the fluorine compound containing chlorine is ClF₃, for example, it is desirable that heating should be carried out up to a temperature of 250°C to 800°C and preferably 350°C to 500°C.

For the fluorine gas concentration/separation refining device 44, furthermore, it is possible to utilize a separating device using distillation and fractional distillation or a liquid trapping method, in which a fluorine gas component is separated from a component other than the fluorine gas component by utilizing a difference in a boiling point through a refrigerant, that is, a difference in a vapor pressure. Furthermore, a separating device using adsorption or desorption through a molecular sieve or the like, a film separating device or the like can be also used.

In this case, a refrigerant such as liquid nitrogen, dry ice or an electron cooler can be used for a cooling agent to be utilized in the separating device. More specifically, it is preferable that external cooling should be carried out by using the liquid nitrogen. As a result, the fluorine gas component and the component other than the fluorine gas component is cooled and fractionally distilled so that the fluorine gas component is separated from the component other than the fluorine gas component, for example.

Examples of the desired compound for chamber cleaning based on the fluorocompound include an adherend comprising a silicon compound which is adhered to a CVD chamber wall, a jig of a CVD apparatus or the like by a CVD method or the like. Examples of the adherend of such a silicon compound include at least one of:
(1) a compound comprising silicon,
(2) a compound comprising at least one of oxygen, nitrogen, fluorine and carbon, and silicon, or
(3) a compound comprising a high-melting-point metal silicide. More specifically, for example, it is possible to use a high-melting-point metal silicide such as Si, SiO₂, Si₃N₄ or WSi.

Moreover, it is desirable that the flow of the fluorine component gas to be introduced into the reaction chamber 12 should be 0.1 to 10 L/min and preferably 0.5 to 1 L/min in consideration of the effect obtained by cleaning a by-product adhered to the inner wall of the chamber 12. More specifically, if the flow of the cleaning gas to be introduced into the reaction chamber 12 is less than 0.1 L/min, the cleaning effect cannot be expected. To the contrary, if the flow of the introduction is more than 10 L/min, the amount of the cleaning gas to be discharged to the outside is increased without contributing to the cleaning.

The flow of the introduction can be properly changed depending on the type, size or the like of the base material A, for example, a flat panel disc. As an example, it is preferable that the flow of the introduction should be set to be 0.5 to 5 L/min as for F₂ to be supplied from the fluorine gas generating device.

In consideration of the effect obtained by cleaning the by-product adhered to the inner wall of the chamber 12, furthermore, it is desirable that the pressure of the cleaning gas in the reaction chamber 12 should be 10 to 2000 Pa and preferably 50 to 500 Pa. More specifically, if the pressure of the cleaning gas in the reaction chamber 12 is lower than 10 Pa or is higher than 2000 Pa, the cleaning effect cannot be expected. The pressure in the reaction chamber 12 can be properly changed depending on the type, size or the like of the base material A, for example, a flat panel disc. As an example, it is preferable that the pressure should be 100 to 500 Pa if 30% of the fluorine gas component is contained.

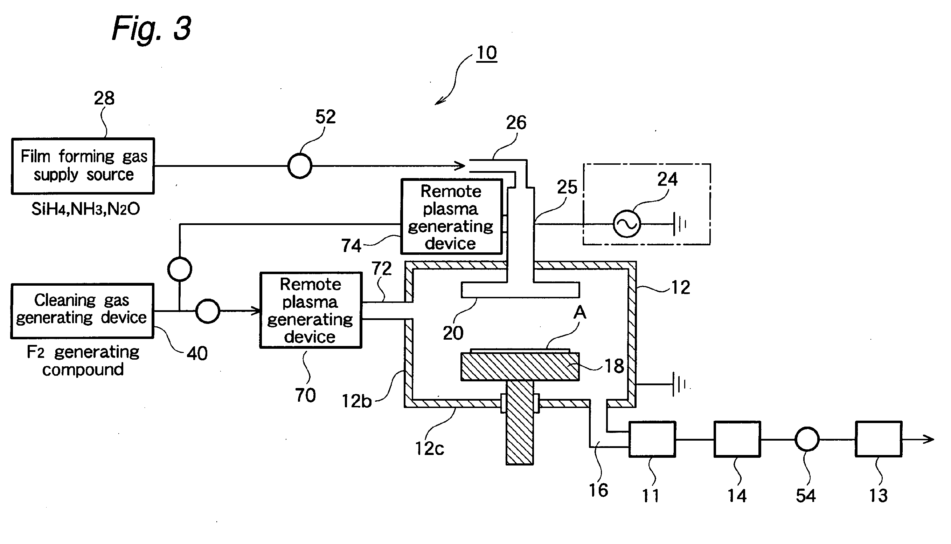

Fig. 3 is a schematic view showing a second example of the CVD apparatus having the cleaning mechanism according to the present invention.

The CVD apparatus 10 according to the present example has basically the same structure as that of the CVD apparatus 10 shown in Fig. 1, and the same components have the same reference numerals and detailed description thereof will be omitted.

The CVD apparatus 10 according to the example in Fig. 1 is constituted to introduce the cleaning gas supplied from the cleaning gas generating device 40 into the reaction chamber 12 through the cleaning gas supply path 30. On the contrary, in the CVD apparatus 10 according to the present example as shown in Fig. 3, a cleaning gas containing a fluorine gas component is converted to a plasma by a remote plasma generating device 70 and the resultant plasma is introduced from a side wall 12b of the reaction chamber 12, which is maintained in a decompression state, into the reaction chamber 12 through a connecting piping 72.

In this case, the material of the connecting piping 72 is not particularly restricted but it is desirable to use alumina, inactivated aluminum, a fluororesin, a metal coated with a fluororesin and the like, for example, in consideration of the effect of preventing the reduction in a gasification efficiency.

Although the remote plasma generating device 70 and the reaction chamber 12 are so arranged that a cleaning gas converted to a plasma is introduced from the chamber side wall 12b through the connecting piping 72 in the present example, it is not restricted but it is sufficient that the cleaning gas is directly introduced into the reaction chamber 12 and the cleaning gas may be introduced from the top wall 12a or the bottom wall 12c in the chamber 12, for example.

As shown in Fig. 3, furthermore, it is also possible to introduce the cleaning gas converted to a plasma from the high frequency applying device 25, which is provided above the reaction chamber 12, into the reaction chamber 12 through a remote plasma generating device 74.

### Examples

Description will be given to a specific example of a cleaning method using the CVD apparatus having the cleaning mechanism according to the present invention.

### Example 1

### Cleaning using a fluorine compound (FNO) containing nitrogen

As shown in Fig. 1, a silicon wafer was mounted on the stage of the lower electrode 18 of the reaction chamber 12 and monosilane (SiH₄) and N₂O were supplied in a ratio of 70 : 2000 as a film forming gas from the film forming gas supply source 28. The inside of the reaction chamber 12 was maintained in a decompression state of 200 Pa and a high frequency electric field of 13.56 Hz was generated from the high frequency applying device 25 over the upper electrode 20. As a result, a high frequency plasma was formed so that a thin SiO₂ film was formed on the surface of the base material A of the silicon wafer.

In this case, a by-product such as SiO₂ was adhered to and deposited on the surfaces of an internal wall, an electrode and the like in the reaction chamber 12.

In the cleaning gas generating device 40, then, FNO was used as a cleaning gas material comprising a fluorine compound and was diluted with Ar (FNO 75%). By using a plasma generating device as the energy applying device 42, the FNO was reacted so that NO, NO₂ or the like and F₂ were generated.

Thereafter, the NO, the NO₂ or the like and the F₂ thus generated were trapped with liquid nitrogen to concentrate and separate the F₂ by using a distilling device as the fluorine gas concentration/separation refining device 44.

The F₂ thus separated was introduced as a cleaning gas into the reaction chamber 12 through the cleaning gas supply path 30. The inside of the reaction chamber 12 was maintained in a decompression state of 250 Pa. In this state, a high frequency electric field of 13.56 MHz was generated from the high frequency applying device 25 over the upper electrode 20, thereby forming a high frequency plasma. An ion or F radical thus generated reacted to a by-product such as SiO₂, which was adhered to and deposited on the surfaces of the inner wall, the electrode and the like in the reaction chamber. As a result, the by-product was changed into a gas as SiF₄. Then, the by-product thus changed into the gas was discharged through the exhaust path 16. Such a cleaning process was carried out for 60 seconds.

By the cleaning process, an increase in particles such as SiO₂, which was adhered to the surfaces of the internal wall, the electrode and the like in the reaction chamber 12, was not observed.

### Example 2

### Cleaning using a fluorine compound (ClF₃) containing chlorine

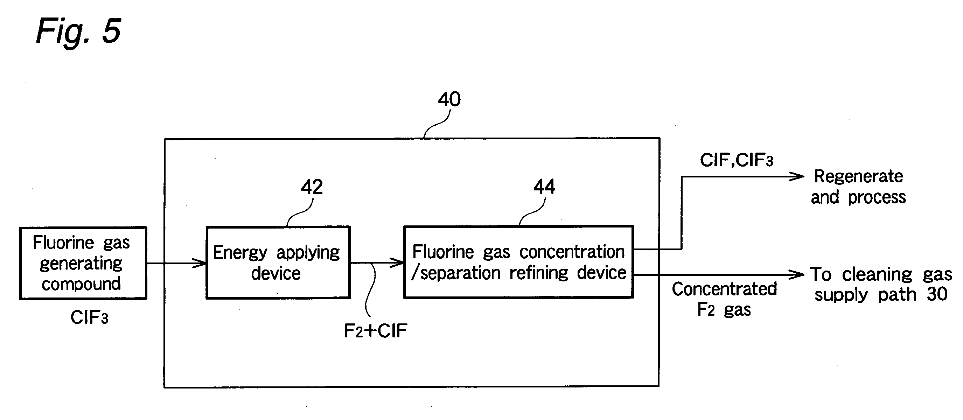

As shown in Fig. 5, a thin SiO₂ film was formed on the surface of the base material A of a silicon wafer in the same manner as in the example 1. In this case, a by-product such as SiO₂ was adhered to and deposited on the surfaces of an internal wall, an electrode and the like in the reaction chamber 12.

In the cleaning gas generating device 40, then, ClF₃ was used as a cleaning gas material comprising a fluorine compound, and a heating device was used as the energy applying device 42. As a result, the ClF₃ was thermally decomposed at an atmospheric pressure and a temperature of 450°C through heating in an electric furnace, so that ClF and F₂ were generated.

Then, the ClF and the F₂ thus generated were separated into the ClF and the F₂ by using a distilling device as the fluorine gas concentration/separation refining device 44 and liquid nitrogen as a refrigerant.

The F₂ thus separated was introduced as a cleaning gas into the reaction chamber 12 through the cleaning gas supply path 30. The inside of the reaction chamber 12 was maintained in a decompression state of 250 Pa at an electrode temperature of 300°C. In this state, a high frequency electric field of 13.56 MHz was generated from the high frequency applying device 25 over the upper electrode 20, so that a high frequency plasma was formed. An ion or F radical thus generated reacted to a by-product such as SiO₂ which was adhered to and deposited on the surfaces of an inner wall, an electrode and the like in the reaction chamber 12.' As a result, the by-product was changed into a gas as SiF₄. Then, the by-product thus changed into the gas was discharged through the exhaust path 16. Such a cleaning process was carried out for 60 seconds.

By the cleaning process, an increase in particles such as SiO₂, which was adhered to the surfaces of the internal wall, the electrode and the like in the reaction chamber 12, was not observed.

### Example 3

### Cleaning using a fluorine compound (COF₂) containing carbon

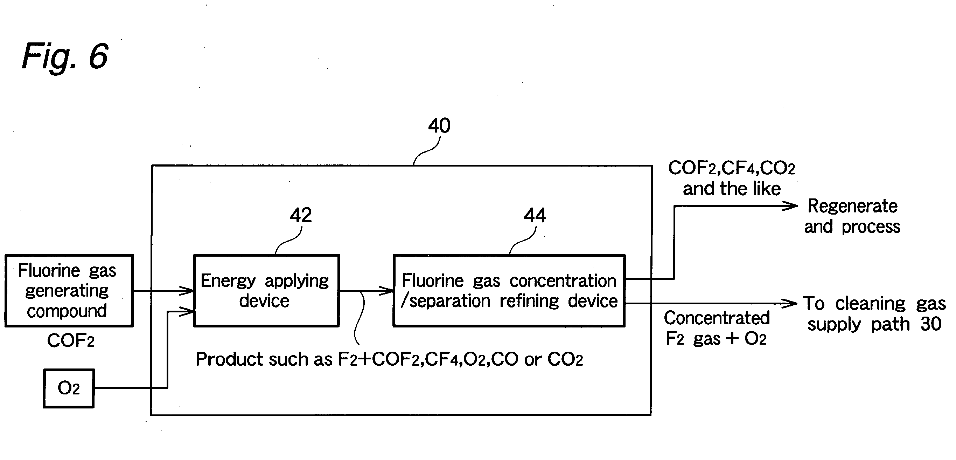

As shown in Fig. 6, SiH₄, NH₃ and N₂ were supplied in a ratio of 180 : 320 : 1000 to form a thin SiN film on the surface of the base material A of a silicon wafer in the same manner as in the example 1. In this case, a by-product such as Si₃N₄ was adhered to and deposited on the surfaces of an internal wall, an electrode and the like in the reaction chamber 12.

In the cleaning gas generating device 40, then, COF₂ was used as a cleaning gas material comprising a fluorine compound and was supplied to the energy applying device 42 in a mole ratio of COF₂ / O₂ = 9. A plasma generating device was used as the energy applying device 42 and decomposition was carried out at 13.56 MHz and 200 Pa to generate CO, CO₂, F₂ or the like.

The gas thus generated was pressurized to have an atmospheric pressure. By utilizing a liquid trapping device as the fluorine gas concentration/separation refining device 44, then, remaining COF₂, CO₂ or the like was separated by using liquid nitrogen as a refrigerant. Thus, an F₂ gas containing concentrated O₂ was obtained.

The separated F₂ containing the O₂ was introduced as a cleaning gas into the reaction chamber 12 through the cleaning gas supply path 30. The inside of the reaction chamber 12 was maintained in a decompression state of 200 Pa at a substrate temperature of 300°C. In this state, a high frequency electric field of 13.56 MHz was generated from the high frequency applying device 25 over the upper electrode 20, thereby forming a high frequency plasma. An ion or F radical thus generated reacted to a by-product such as SiO₂, which was adhered to and deposited on the surfaces of an inner wall, an electrode and the like in the reaction chamber 12. As a result, the by-product was changed into a gas as SiF₄. Then, the by-product thus changed into the gas was discharged through the exhaust path 16. Such a cleaning process was carried out for 60 seconds.

By the cleaning process, an increase in particles such as Si₃N₄, which was adhered to the surfaces of the internal wall, the electrode and the like in the reaction chamber 12, was not observed.

While the examples of the cleaning device in the plasma CVD apparatus according to the present invention have been described above, the formation of a silicon thin film has been described in the above examples without departing from the scope of the present invention, for example. The examples can also be applied to the case in which a thin film such as another silicon germanium film (SiGe), a silicon carbide film (SiC), an SiOF film, an SiON film or a carbonaceous SiO₂ film is to be formed.

Although the horizontal apparatus has been described in the examples, moreover, it is also possible to use a vertical apparatus in place thereof. While the leaf type has been described in the examples, furthermore, the present invention can also be applied to a batch type CVD apparatus.

While the present invention has been applied to the plasma CVD apparatus in the examples, moreover, it is a matter of course that various changes can be made. That is, the present invention can also be applied to other CVD methods such as a vacuum deposition method in which a thin film material is deposited on a substrate by thermal decomposition, oxidation, reduction, polymerization, vaporization reaction or the like at a high temperature.

While the preferred examples of the present invention have been described above, the present invention is not restricted thereto but various changes can be made without departing from the scope of the present invention.

### Effect of the Invention

According to the present invention, the energy is simply applied to react the fluorine compound so that the fluorine gas component and the component other than the fluorine gas component are generated and separated. Consequently, the fluorine gas component is simply separated and refined so that the fluorine gas can easily be obtained.

Accordingly, the film forming process for the base material is carried out by the CVD apparatus and the fluorine gas thus obtained is then converted to a plasma. By using the plasma to remove a by-product adhered into the reaction chamber, it is possible to obtain a very excellent etching speed. Thus, an excellent cleaning uniformity can be maintained.

In addition, such a fluorine gas generating device has a smaller size as compared with a conventional fluorine gas generating device using electrolysis, and furthermore, the fluorine gas can be obtained efficiently. The CVD apparatus itself is also small-sized and maintenance can easily be carried out.

According to the present invention, moreover, by simply heating the fluorine compound, the fluorine compound is reacted to generate the fluorine gas component and the component other than the fluorine gas component. Thus, the fluorine gas component can be obtained. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

According to the present invention, furthermore, by simply applying a plasma to the fluorine compound, the fluorine compound is reacted to generate the fluorine gas component and the component other than the fluorine gas component. Thus, the fluorine gas component can be obtained. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

According to the present invention, moreover, the fluorine gas component is separated from the component other than the fluorine gas component by utilizing a difference in a boiling point, that is, a difference in a vapor pressure through cooling. Therefore, a size can be more reduced as compared with a conventional fluorine gas generating device using electrolysis, and furthermore, the fluorine gas can be obtained efficiently. The CVD apparatus itself is also small-sized and the maintenance can easily be carried out.

According to the present invention, moreover, the fluorine compound contains nitrogen. Therefore, examples of the fluorine compound containing the nitrogen include FNO and F₃NO. The FNO is a stable substance. By using the FNO as a fluorine gas source, it is possible to use the fluorine gas as a cleaning gas more stably.

According to the present invention, furthermore, the fluorine compound contains chlorine. Therefore, if the fluorine compound containing the chlorine is ClF₃, for example, the ClF₃ is decomposed into ClF and F₂. Referring to the ClF and the F₂, the boiling point of the ClF is -101°C and that of the F₂ is -188.1°C, which are different from each other. By using a cooling agent such as liquid nitrogen or dry ice, for example, it is possible to easily separate the fluorine gas.

According to the present invention, moreover, the fluorine compound contains iodine. Therefore, if the fluorine compound containing the iodine is IF₅ or IF₇, for example, a product such as IF₃ has a different boiling point from that of F₂. Therefore, it is possible to easily separate the fluorine gas by using a cooling agent such as liquid nitrogen or dry ice.

According to the present invention, furthermore, the fluorine compound contains sulfur. Therefore, if the fluorine compound containing the sulfur is SF₆, for example, products such as SO₂F₂, SO₂ and the like have different boiling points from each other. That is, the boiling point of the SO₂F₂ is -83.1°C, that of the SO₂ is -10°C and that of F₂ is -188.1°C. By carrying out trapping or the like using liquid nitrogen, dry ice or the like, for example, it is possible to easily separate the fluorine gas.

According to the present invention, moreover, the fluorine compound contains carbon. Therefore, if the fluorine compound containing the carbon is CF₄, COF₂ or C₂F₆, for example, products such as CO₂ (a boiling point of -78.5°C), the COF₂ (a boiling point of -83.1°C), the C₂F₂ (a boiling point of -78.2°C) and the CF₄ have different boiling points from the boiling point of the F₂ (a boiling point of -188.1°C). Therefore, it is possible to easily separate the fluorine gas by carrying out trapping or the like using liquid nitrogen, dry ice or the like, for example. Thus, the present invention is very excellent and can produce various remarkable and special functions and effects.

## Claims

1. A CVD apparatus having a cleaning mechanism for supplying a reactive gas into a reaction chamber and forming a deposited film on a surface of a base material provided in the reaction chamber, comprising a fluorine gas generating device including:
an energy applying device configured to apply an energy to a fluorine compound to react the fluorine compound, thereby generating a fluorine gas component and a component other than the fluorine gas component; and
a fluorine gas concentration/separation refining device configured to separate the fluorine gas component and the component other than the fluorine gas component which are generated by the energy applying device, thereby separating and refining the fluorine gas component,
wherein after a film forming process for the base material is carried out by the CVD apparatus, a fluorine gas, which is separated and refined by the fluorine gas generating device, is then converted to a plasma to remove a by-product adhered into the reaction chamber.

2. The CVD apparatus having a cleaning mechanism according to claim 1, wherein the energy applying device is constituted to heat the fluorine compound, thereby reacting the fluorine compound to generate the fluorine gas component and the component other than the fluorine gas component.

3. The CVD apparatus having a cleaning mechanism according to claim 1, wherein the energy applying device is constituted to apply a plasma to the fluorine compound, thereby reacting the fluorine compound to generate the fluorine gas component and the component other than the fluorine gas component.

4. The CVD apparatus having a cleaning mechanism according to claim 1, wherein the energy applying device is constituted to react the fluorine compound by a catalyst, thereby generating the fluorine gas component and the component other than the fluorine gas component.

5. The CVD apparatus having a cleaning mechanism according to any of claims 1 to 4, wherein the fluorine gas concentration/separation refining device is constituted to separate the fluorine gas component from the component other than the fluorine gas component by utilizing a difference in a boiling point which is made by cooling.

6. The CVD apparatus having a cleaning mechanism according to any of claims 1 to 5, wherein the fluorine compound contains nitrogen.

7. The CVD apparatus having a cleaning mechanism according to any of claims 1 to 5, wherein the fluorine compound contains chlorine.

8. The CVD apparatus having a cleaning mechanism according to any of claims 1 to 5, wherein the fluorine compound contains iodine.

9. The CVD apparatus having a cleaning mechanism according to any of claims 1 to 5, wherein the fluorine compound contains sulfur.

10. The CVD apparatus having a cleaning mechanism according to any of claims 1 to 5, wherein the fluorine compound contains carbon.

11. A method of cleaning a CVD apparatus for supplying a reactive gas into a reaction chamber and forming a deposited film on a surface of a base material provided in the reaction chamber, comprising:
applying an energy to a fluorine compound to react the fluorine compound, thereby generating a fluorine gas component and a component other than the fluorine gas component; and
separating the fluorine gas component and the component other than the fluorine gas component which are generated, thereby separating and refining the fluorine gas component,
wherein after a film forming process for the base material is carried out by the CVD apparatus, a separated and refined fluorine gas is then converted to a plasma to remove a by-product adhered into the reaction chamber.

12. The method of cleaning a CVD apparatus according to claim 11, wherein the fluorine compound is heated and is thus reacted, thereby generating the fluorine gas component and the component other than the fluorine gas component.

13. The method of cleaning a CVD apparatus according to claim 11, wherein a plasma is applied to the fluorine compound, thereby reacting the fluorine compound to generate the fluorine gas component and the component other than the fluorine gas component.

14. The method of cleaning a CVD apparatus according to claim 11, wherein the fluorine compound is reacted by a catalyst, thereby generating the fluorine gas component and the component other than the fluorine,gas component.

15. The method of cleaning a CVD apparatus according to any of claims 11 to 14, wherein the fluorine gas component is separated from the component other than the fluorine gas component by utilizing a difference in a boiling point which is made by cooling.

16. The method of cleaning a CVD apparatus according to any of claims 11 to 15, wherein the fluorine compound contains nitrogen.

17. The method of cleaning a CVD apparatus according to any of claims 11 to 15, wherein the fluorine compound contains chlorine.

18. The method of cleaning a CVD apparatus according to any of claims 11 to 15, wherein the fluorine compound contains iodine.

19. The method of cleaning a CVD apparatus according to any of claims 11 to 15, wherein the fluorine compound contains sulfur.

20. The method of cleaning a CVD apparatus according to any of claims 11 to 15, wherein the fluorine compound contains carbon.
